# FASCICULE DE BREVET EUROPEEN

(11) **EP 2 979 308 B1**
(45) Date de publication et mention de la délivrance du brevet: **14.08.2019**
(21) Numéro de dépôt: 14715249.0
(22) Date de dépôt: 28.03.2014
(51) Int. Cl.: H01L 33/08, H01L 33/18, H01L 33/38, B82Y 20/00, H01L 33/24, H01L 33/32, H01L 33/06, H01L 23/00, H01L 33/60, H01L 33/54, H01L 33/42

(54) **DISPOSITIF ÉLECTROLUMINESCENT À NANOFILS ACTIFS ET NANOFILS DE CONTACT ET PROCÉDÉ DE FABRICATION**
LICHT-EMITTIERENDE VORRICHTUNG MIT AKTIVEN NANODRÄHTEN UND KONTAKTNANODRÄHTEN SOWIE HERSTELLUNGSVERFAHREN
LIGHT-EMITTING DEVICE WITH ACTIVE NANOWIRES AND CONTACT NANOWIRES AS WELL AS MANUFACTURING METHOD

(30) Priorité: 28.03.2013 FR 1352805
(43) Date de publication de la demande: 03.02.2016
(73) Titulaire: Aledia, 38040 Grenoble Cedex (FR)
(72) Inventeur: SCARINGELLA, Sylvia, F-38320 Eybens (FR); GILET, Philippe, F-38470 Teche (FR); HUGON, Xavier, F-38470 Teche/Vinay (FR); GIBERT, Philippe, F-38960 Saint Etienne de Crossey (FR)
(74) Mandataire: Esselin, Sophie
(86) Numéro de dépôt international: PCT/EP2014/056330
(87) Numéro de publication internationale: WO 2014/154880

(56) Documents cités:
- EP-A1- 2 290 710
- WO-A1-2010/014032
- WO-A2-2012/156620
- US-A1- 2010 193 811
- US-A1- 2011 240 959
- US-A1- 2011 309 382
- US-A1- 2012 168 613
- US-A1- 2012 223 289
- US-B1- 8 350 251

## Description

Le domaine de l'invention est celui des composants à base de nanofils, réalisés collectivement par croissance localisée sur un substrat pouvant être en silicium, ou en GaN ou en en saphir, ou autre.

Plus précisément, le domaine de l'invention peut adresser des composants à base de nanofils photoconducteurs ou photo-émetteurs pouvant être utilisés par exemple pour produire de la lumière, notamment des diodes électroluminescentes, couramment désignées par l'acronyme LED (« Light Electroluminescent Diode »). Typiquement les nanofils présentent de manière générale des dimensions latérales (diamètre) pouvant être de l'ordre de quelques centaines de nanomètres et une dimension verticale pouvant varier jusqu'à une dizaine de micromètres, avec un rapport hauteur / diamètre allant de 1 à 30 et typiquement autour de 10.

Les documents US2011/240959-A1, US8350251-B1 et JP2008-108757-A présentent des dispositifs de l'art antérieur.

Au cours de ces dernières années, il a été réalisé par exemple, des diodes électroluminescentes (LEDs) visibles à base de nanofils InGaN/GaN verticaux contenant une jonction p-n et connectés collectivement en parallèle.

Grâce à leurs propriétés intrinsèques potentielles (bonne qualité cristalline, relaxation des contraintes aux surfaces libres verticales, bonne efficacité d'extraction de la lumière,...), les nanofils sont considérés comme des candidats très intéressants pour pallier les difficultés rencontrées actuellement avec des LEDs GaN conventionnelles fabriquées en structure planaire (2D).

Deux approches LEDs Nanofils, basées sur des techniques de croissance différentes, ont déjà été proposées et sont connues de l'homme de l'art.

La première filière consiste à épitaxier des nanofils GaN contenant des puits quantiques InGaN en configuration axiale par Epitaxie par Jet Moléculaire (MBE). Les dispositifs fabriqués à partir de ces nanofils ont donné des résultats intéressants dans le domaine spectral vert. Les puces processées de 1 mm² peuvent émettre autour de 10 µW à 550 nm pour un courant continu de fonctionnement de 100 mA.

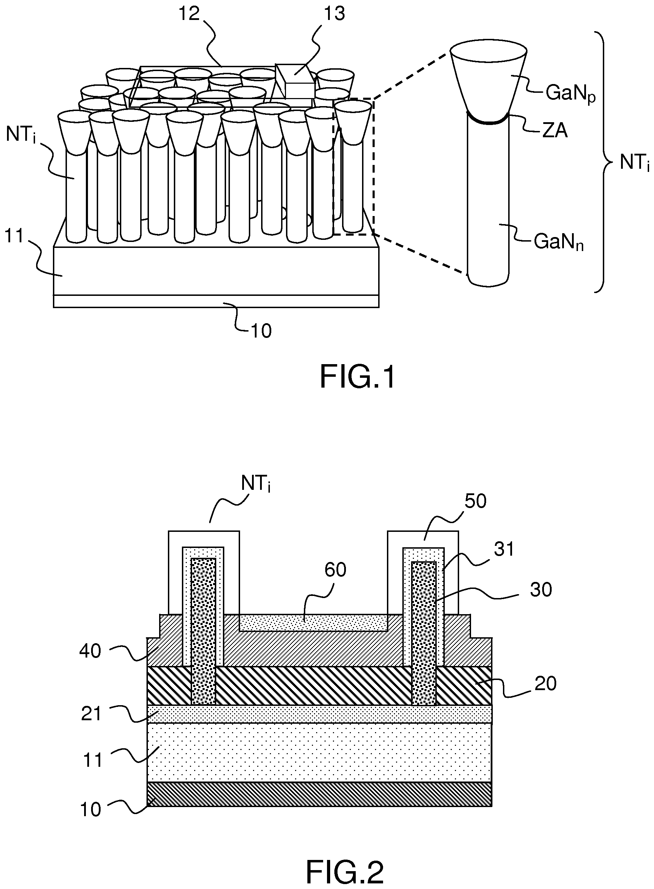

La figure 1 illustre une telle configuration mettant en évidence des nanofils NTᵢ à la surface d'un substrat 11 typiquement en silicium en contact avec un contact inférieur de type n 10, le contact supérieur de type p étant assuré par une couche transparente 12 et la reprise de contact effectuée par une reprise de contact p, épaisse 13. Les nanofils NTᵢ de structure axiale comportent une zone dopée n pouvant typiquement être en GaN dopée n, une zone active ZA en InGaN ou possédant une structure à puits quantique, et une zone dopée p pouvant être en GaN dopée p.

Avec la technique de croissance par jets moléculaires (MBE), certaines inhomogénéités apparaissent en raison de mécanismes de nucléation aléatoire, mais typiquement il a été obtenu une puissance optique sur un fil unique émettant à 550nm de 50nW, soit 5 W/mm² avec une centaine de nanofils émetteurs/mm².

Plus récemment, la technique de croissance MOCVD (dépôt chimique en phase vapeur à base d'organométalliques) a permis la réalisation de nanofils InGaN/GaN contenant une structure LED radiale (configuration Coeur/Coquille).

La figure 2 illustre ce type de configuration dans laquelle, des nanofils NTᵢ sont réalisés à la surface d'un substrat 11 recouvert d'une couche de nucléation 21, une couche de contact inférieur 10 étant également prévue. L'épitaxie localisée est assurée au travers d'un masque 20. La structure des nanofils est de type coeur/coquille. Le coeur 30 peut comprendre un matériau GaN dopé n, typiquement avec un taux de dopage de 10¹⁹ cm⁻³, une structure à puits quantique avec une alternance de couches, pouvant respectivement être en GaN non dopée et InGaN, et enfin une coquille 31 pouvant être constituée d'une couche GaN dopée p avec typiquement un taux de dopage de 10¹⁹ cm⁻³.

Une couche diélectrique 40 assure l'isolation entre les contacts inférieur et supérieur.

Le contact supérieur est assuré via une couche supérieure 50, conductrice et transparente à la longueur d'onde d'émission de la structure photoconductrice. Une couche de contact métallique 60 étant également prévue pour assurer une fonction miroir.

Dans cette approche, la structure LED étant en configuration Coeur/Coquille, la surface de la zone active est plus importante que dans une approche LEDs nanofils 2D comportant des structures planaires.

Néanmoins, le Demandeur est parti du constat que les procédés d'épitaxie tel que le procédé MOCVD génèrent de par toute la consommation d'espèces gazeuses, des effets de bord préjudiciables à l'obtention de composants homogènes, et des discontinuités dans les zones de croissance des nanofils, plus précisément, une variation sur la plaque du taux de surface de croissance.

En effet, notamment dans le cas des LEDs, les nanofils fabriqués par épitaxie par exemple de GaN sur des motifs de croissances peuvent être définis par les techniques standards de la microélectronique.

Ces motifs sont regroupés sur le substrat sous la forme de motifs réguliers dans des zones compactes, carrées, rondes, hexagonales, triangulaires.... qui définissent la surface active de la LED. Ces zones ont des dimensions définies par les besoins du client final du produit, par exemple 100 µm par 100 µm, 350 µm par 350 µm, 1mm par 1 mm, 3,5 mm par 3,5 mm, 10 mm par 10 mm. Chaque zone de croissance est séparée de sa voisine par un espacement dont la dimension est ajustée au minimum pour permettre le passage des connexions métalliques d'alimentation des LED et la découpe par sciage des substrats, ou autre technique de découpe.

Ces espacements entre les zones de croissances, dans lesquels aucune épitaxie n'est souhaitée, provoquent l'apparition de défauts multiples :
- des non-uniformités en hauteurs et en morphologies, dans les réseaux de fils, liées aux discontinuités dans les zones de croissances ;
- des croissances inorganisées de nano-cristaux par exemple de GaN qui sont des défauts tueurs pour les circuits lors de la fin des étapes de technologie ;
- des dépôts de InGaN parasites qui tapissent les surfaces des plaques de matériaux conducteurs.

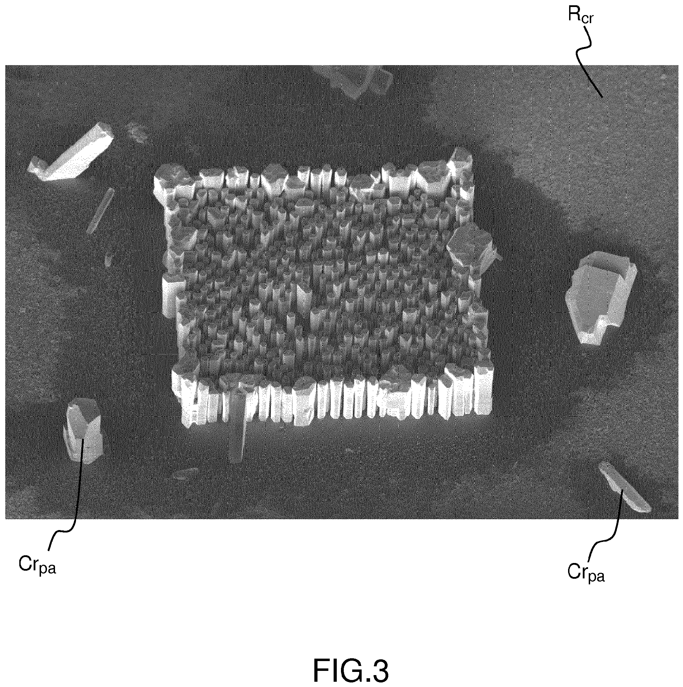

La figure 3 illustre une vue réalisée sur un ensemble de nanofils et un ensemble de défauts apparaissant dans les zones de non-croissance, photographie faite au microscope électronique à balayage, qui met en évidence des croissances parasites Crₚₐ, des dépôts de résidus de croissance R_{cr} et/ou des murailles de nanofils de dimensions non-homogènes en périphérie.

Il peut avantageusement être envisagé une solution permettant notamment d'éliminer les défauts en homogénéisant l'ensemble de la surface d'un substrat en termes de croissance de nanofils et en sélectionnant une zone élémentaire de nanofils parmi l'ensemble plus important de nanofils, permettant ainsi de disposer de support fonctionnel présentant des nanofils homogènes et ce en procédant à l'élimination sélective de certains nanofils pour notamment dégager des zones dédiées au contact ohmique. Néanmoins, le retrait de sous-ensembles de nanofils peut s'avérer être délicat à réaliser entre sous-ensembles de nanofils à conserver.

C'est pourquoi et dans ce contexte, la présente invention propose des LEDs comprenant des nanofils sur l'ensemble du substrat et la réalisation de contacts ohmiques grâce à la présence de métal épais au dessus de certains des nanofils préalablement élaborés, permettant par la même de commander électriquement une partie dite active de nanofils.

Plus précisément, la présente invention a pour objet un dispositif électroluminescent comprenant un ensemble de nanofils sur l'ensemble de la surface d'un substrat caractérisé en ce que :
- il comprend au moins une première série de premiers nanofils et une seconde série de seconds nanofils ;
- ladite première série comprenant des premiers nanofils dits actifs capables d'émettre de la lumière sous commande électrique, connectés entre un premier type de contact électrique et un second type de contact électrique pour permettre audit dispositif d'émettre de la lumière sous commande électrique, lesdits premiers nanofils étant recouverts d'au moins une couche conductrice transparente à la longueur d'émission dudit dispositif électroluminescent, ladite couche étant en contact avec ledit premier type de contact électrique ;
- ladite seconde série comprenant des seconds nanofils dits de contact encapsulés dans une couche de métal permettant de constituer ledit premier type de contact électrique ;
- le second type de contact électrique étant situé en face arrière dudit substrat, opposée à la face comprenant lesdits nanofils et étant assuré par une couche conductrice au moins en regard de ladite première série de nanofils.

Selon une variante de l'invention, lesdits seconds nanofils sont situés en périphérie desdits premiers nanofils.

Selon une variante de l'invention, lesdits seconds nanofils sont recouverts par ladite couche conductrice transparente à la longueur d'émission dudit dispositif électroluminescent.

Selon une variante de l'invention, le dispositif électroluminescent comprend une troisième série de troisièmes nanofils dits neutres électriquement sans couche conductrice transparente à la longueur d'émission dudit dispositif électroluminescent, lesdits troisièmes nanofils pouvant être situés en périphérie desdits premiers nanofils actifs et desdits seconds nanofils, définissant une zone dite active dudit dispositif.

Selon une variante de l'invention, l'épaisseur de la couche de métal définie au dessus desdits seconds nanofils est de l'ordre d'au moins quelques dizaines de nanomètres.

Selon une variante de l'invention, le dispositif électroluminescent comprend une couche conductrice transparente à la longueur d'émission dudit dispositif électroluminescent, pouvant être en oxyde d'indium et d'étain (ITO), ou en oxyde de zinc dopé aluminium (AZO), ou en oxyde de zinc dopé gallium (GZO) ou en oxyde d'étain dopé fluore (FTO).

Selon une variante de l'invention, la couche de métal encapsulant lesdits seconds nanofils est en cuivre ou en nickel ou en argent.

Selon une variante de l'invention, le dispositif électroluminescent
comporte des plots de contact métalliques à la surface de ladite couche de métal, pouvant être en or ou en alliage d'argent et d'étain.

Selon une variante de l'invention, lesdits seconds nanofils sont recouverts par une couche continue ou discontinue d'accroche pour le métal, pouvant être en cuivre ou en aluminium.

Selon une variante de l'invention, le dispositif électroluminescent comprend une couche discontinue d'isolant encapsulant la base desdits nanofils et étant située à la surface dudit substrat entre lesdits nanofils.

Selon une variante de l'invention, le dispositif électroluminescent comprend une couche miroir située entre deux nanofils adjacents, pouvant être en Al ou en Ag ou en Ru.

L'invention a aussi pour objet un procédé de fabrication de dispositif(s) électroluminescent(s) comprenant :
- un ensemble de nanofils sur l'ensemble de la surface d'un substrat ;
- au moins une première série de premiers nanofils et une seconde série de seconds nanofils ;
- ladite première série comprenant des premiers nanofils dits actifs capables d'émettre de la lumière sous commande électrique, connectés entre un premier type de contact électrique et un second type de contact électrique pour permettre audit dispositif d'émettre de la lumière sous commande électrique, lesdits premiers nanofils étant recouverts d'au moins une couche conductrice transparente à la longueur d'émission dudit dispositif électroluminescent, ladite couche étant en contact avec ledit premier type de contact électrique ;
- ladite seconde série comprenant des seconds nanofils dits de contact encapsulés dans une couche de métal permettant de constituer ledit premier type de contact électrique ;
- le second type de contact électrique étant situé en face arrière dudit substrat, opposée à la face comprenant lesdits nanofils et étant assuré par une couche conductrice au moins en regard de ladite première série de nanofils.
caractérisé en ce qu'il comporte les étapes suivantes :
- la croissance de nanofils sur l'ensemble de la surface d'un substrat ;
- le dépôt d'une couche conductrice transparente à la longueur d'onde de fonctionnement du dispositif électroluminescent, à la surface d'au moins une partie desdits nanofils ;
- l'encapsulation locale par une couche de métal d'un sous-ensemble de nanofils constituant lesdits seconds nanofils dits de contact permettant de constituer ledit premier type de contact électrique ;
- la réalisation du second type de contact en face arrière du substrat, par une couche conductrice au moins en regard de ladite première série de nanofils.

Selon une variante de l'invention, le procédé comprend :
- la réalisation de motifs épais de résine à la surface d'au moins deux premiers sous-ensembles de premiers nanofils laissant au moins un second sous-ensemble de seconds nanofils non recouverts de ladite résine ;
- le dépôt d'une couche de métal, à la surface desdits seconds nanofils pour assurer le premier type de contact électrique ;
- le retrait desdits motifs de résine au niveau desdits premiers nanofils.

Selon une variante de l'invention, le procédé comprend le dépôt d'une couche de métal pouvant être une encre métallique, à la surface desdits seconds nanofils, par sérigraphie au travers d'un masque pour assurer le premier type de contact électrique.

Selon une variante de l'invention, le procédé comprend une étape de réalisation de plots conducteurs à la surface de ladite couche de métal.

Selon une variante de l'invention, le procédé comprend le dépôt localisé d'une couche de métal, à la surface desdits seconds nanofils, avec un dispenseur pour assurer le premier type de contact électrique.

Selon une variante de l'invention, le procédé comprend le dépôt localisé d'une couche de métal à la surface desdits seconds nanofils, par jet d'encre pour assurer le premier type de contact électrique.

Selon une variante de l'invention, le procédé comporte une étape de retrait de la couche conductrice et transparente à la longueur d'onde d'émission dudit dispositif électroluminescent au niveau de nanofils situés en périphérie desdits premiers et seconds nanofils, de manière à définir une troisième série de troisièmes nanofils.

Selon une variante de l'invention, le dépôt de la couche de métal et/ou la réalisation des plots conducteurs sont effectués par une opération d'électrodéposition.

Selon une variante de l'invention, le procédé comprend le dépôt d'une couche miroir entre deux nanofils adjacents, ledit dépôt étant préalable ou postérieur au dépôt de ladite couche conductrice transparente.

Lorsque la couche de métal est réalisée par électrodéposition :
- selon une variante de l'invention, le procédé comprend le dépôt d'au moins une couche d'accroche destinée à l'accroche dudit métal, ledit dépôt pouvant être réalisé :
   ∘ de manière continue sur l'ensemble desdits nanofils et entre deux nanofils adjacents au niveau dudit substrat ou;
   ∘ de manière discontinue aux extrémités desdits nanofils et entre deux nanofils adjacents au niveau dudit substrat ou ;
   ∘ entre deux nanofils adjacents au niveau dudit substrat ;
- selon une variante de l'invention, le procédé comprend le dépôt d'une couche à base de cuivre ou d'aluminium pouvant avantageusement être déposée sur une fine couche préalablement déposée à base de titane ;
- selon une variante de l'invention, le procédé comprend une opération de retrait de ladite couche d'accroche au niveau desdits troisièmes nanofils ou desdits troisièmes nanofils et desdits premiers nanofils.

L'invention sera mieux comprise et d'autres avantages apparaîtront à la lecture de la description qui va suivre donnée à titre non limitatif et grâce aux figures annexées parmi lesquelles :
- la figure 1 illustre un premier exemple de LED comprenant des nanofils selon l'art connu ;
- la figure 2 illustre un second exemple de LED comprenant des nanofils selon l'art connu ;
- la figure 3 illustre une vue d'un ensemble de nanofils séparés par des zones de non croissance dans lesquelles sont présents des défauts dans une configuration de l'art connu ;
- les figures 4a à 4i illustrent les différentes étapes d'un exemple de procédé de fabrication d'un dispositif électroluminescent de l'invention ;
- la figure 5 illustre un exemple de configuration de couche épaisse de contact, à la surface d'un ensemble de nanofils NTi_{c}, situés entre des premiers nanofils NTiₐ et des troisièmes nanofils NTiₙ.
- la figure 6 illustre une vue d'ensemble d'un exemple de dispositif selon l'invention reporté sur un boitier.
- les figures 7a à 7d illustrent les différentes étapes d'un second exemple de procédé de fabrication d'un dispositif électroluminescent de l'invention ;
- les figures 8a et 8b illustrent les étapes d'un troisième exemple de procédé de fabrication d'un dispositif électroluminescent de l'invention.

Le dispositif électroluminescent de la présente invention, comprend de manière générale un substrat recouvert de nanofils sur l'ensemble de sa surface, pour ne pas laisser des zones libres dans lesquelles il pourrait y avoir des défauts de croissance, lors de la réalisation des nanofils. Ainsi, selon l'invention, mêmes des zones dédiées aux contacts permettant de commander les nanofils, utilisent la surface supérieure de certains nanofils.

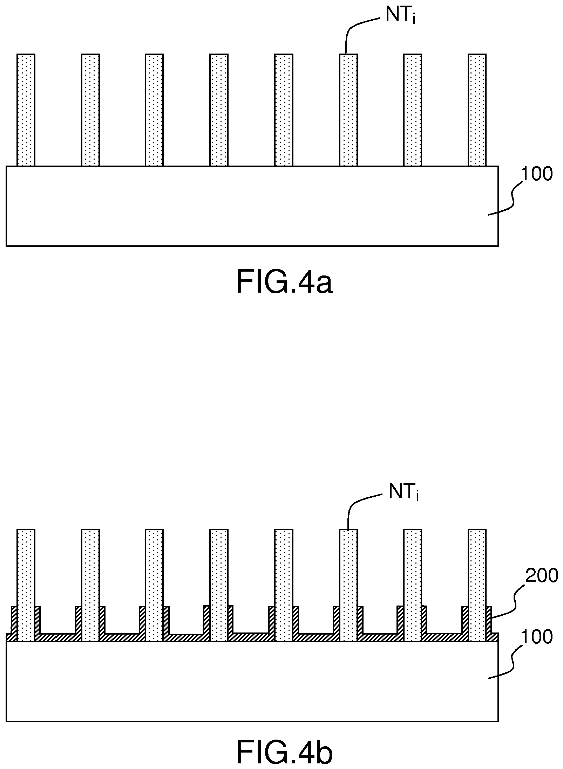

La présente invention, va être décrite ci-après plus en détails grâce à des étapes de procédé de fabrication permettant d'obtenir le dispositif de l'invention. Les différentes étapes sont illustrées grâce aux figures 4a à 4i.

### Etape 1 illustrée en figure 4a :

A partir d'un substrat 100, pouvant avantageusement être en silicium, on réalise sur l'ensemble de ce substrat la croissance des nanofils NTᵢ.

### Etape 2 illustrée en figure 4b :

On procède alors au dépôt d'une couche 200 permettant d'encapsuler partiellement les nanofils, via un diélectrique pouvant typiquement être en SiO₂, Al₂O₃, HfO₂ ou en SiₓN_{y} avec x et y des fractions molaires.

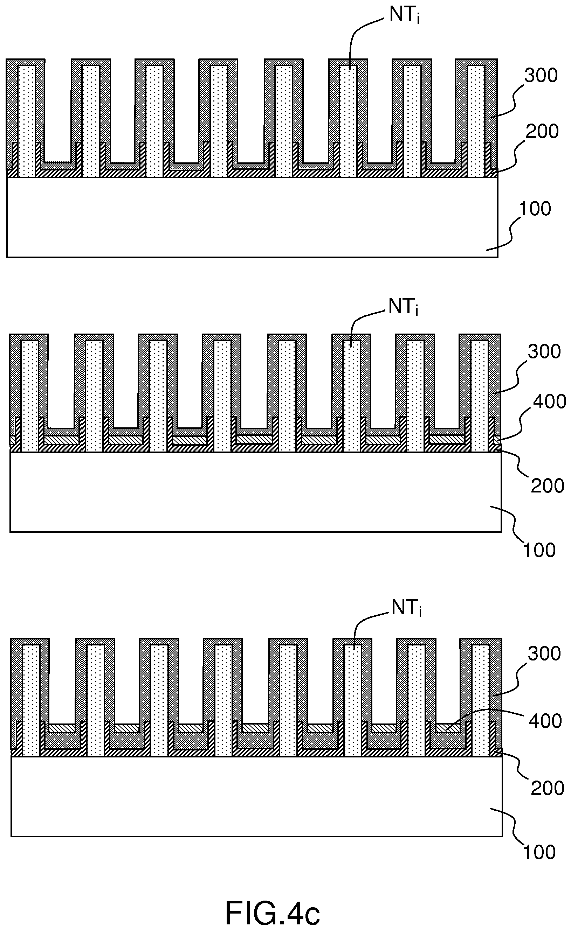

### Etape 3 illustrée en figure 4c :

On procède au dépôt d'une couche 300 conductrice transparente à la longueur d'onde de fonctionnement du dispositif électroluminescent. Typiquement, cette couche peut être déposée sur une première couche en nickel, palladium ou en platine de quelques nanomètres (5 nm). La couche conductrice transparente peut être en ITO d'épaisseur de l'ordre d'une dizaine à une centaine de nanomètres. La couche transparente conductrice peut également être en FTO, AZO ou GZO.

Afin de rediriger les faisceaux vers le haut de la puce, il peut avantageusement être prévu le dépôt également d'une structure miroir 400, cette structure miroir pouvant avoir été déposée préalablement au dépôt de la couche conductrice et transparente ou postérieurement. Cette structure miroir peut être une structure bi-couche de type Ti/Al ou de type Ti/Ag ou de type Ti/Ru. Les différentes alternatives sont représentées en figure 4c.

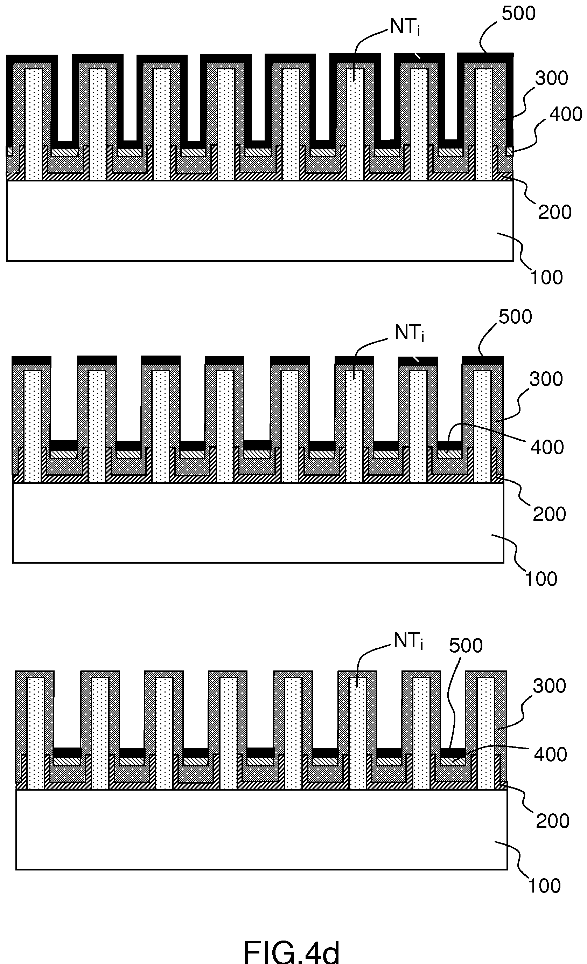

### Etape 4 illustrée en figure 4d :

On procède au dépôt d'une structure 500 de couche(s) d'accroche pour le métal épais destiné à permettre la reprise de contact. Cette structure peut par exemple être composée d'une première couche en titane d'épaisseur de l'ordre de 100 nm et d'une couche de cuivre de l'ordre de 400 nm, et être obtenue par procédé PVD. Cette structure bi-couche peut être réalisée sur l'ensemble des nanofils et des interstices entre nanofils, ou bien de manière discontinue, ces différentes possibilités sont illustrée en figure 4d et peuvent être obtenues en jouant sur les épaisseurs de la bi-couche ou par gravure.

Les structures bi-couches peuvent également être réalisées par les dépôts suivants : une première couche de TiN ou de Ti sous une seconde couche de Cu ou d'Al et ce par PVD ou CVD ou procédé d'évaporation ou procédé par pulvérisation.

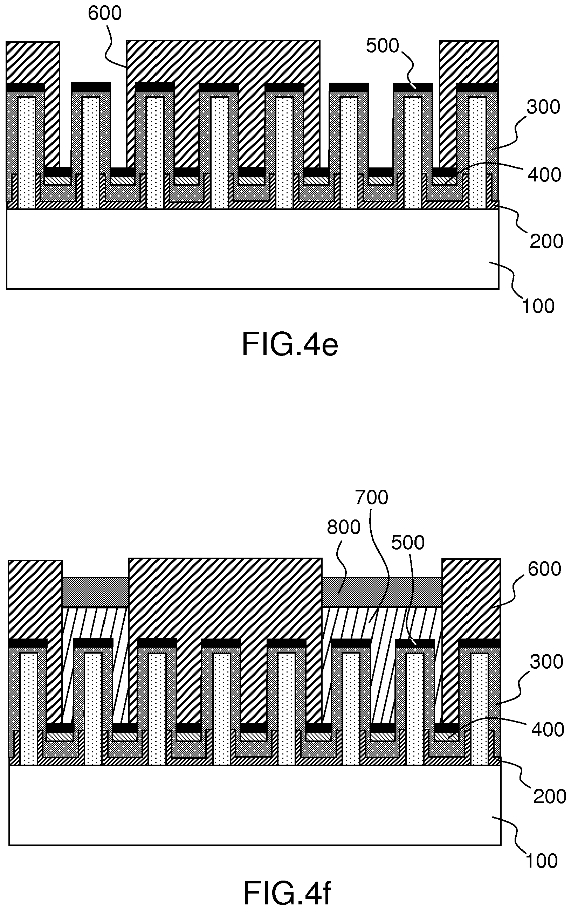

### Etape 5 illustrée en figure 4e :

On réalise par lithographie des motifs de résine 600 permettant de positionner ultérieurement les contacts supérieurs et ainsi définir la zone active du dispositif électroluminescent et permettant par la même d'en individualiser la taille comme explicité ci-après.

### Etape 6 illustrée en figure 4f :

On procède au dépôt d'une couche épaisse de métal pouvant typiquement avoir une épaisseur d' environ une dizaine de nm au dessus desdits nanofils et pouvant atteindre plusieurs microns, entre les motifs de résine, permettant d'identifier deux séries de nanofils :
- une première série de premiers nanofils sous les motifs de résine, ladite résine étant destinée à être retirée pour laisser lesdits premiers nanofils apparents ;
- une seconde série de seconds nanofils sous les motifs de métal épais.

La couche épaisse de métal peut typiquement être en cuivre ou en nickel et réalisée par un procédé d'électrodéposition.

On peut alors réaliser sur cette couche épaisse de métal, des plots 800 de « bonding » destinés à permettre la connexion avec un autre support fonctionnalisé, de type par exemple SnAg, qui donne l'empilement Cu/Ni/SnAg, suivi d'une opération de recuit à 260°C Ces plots de « bonding » peuvent aussi être en Au.

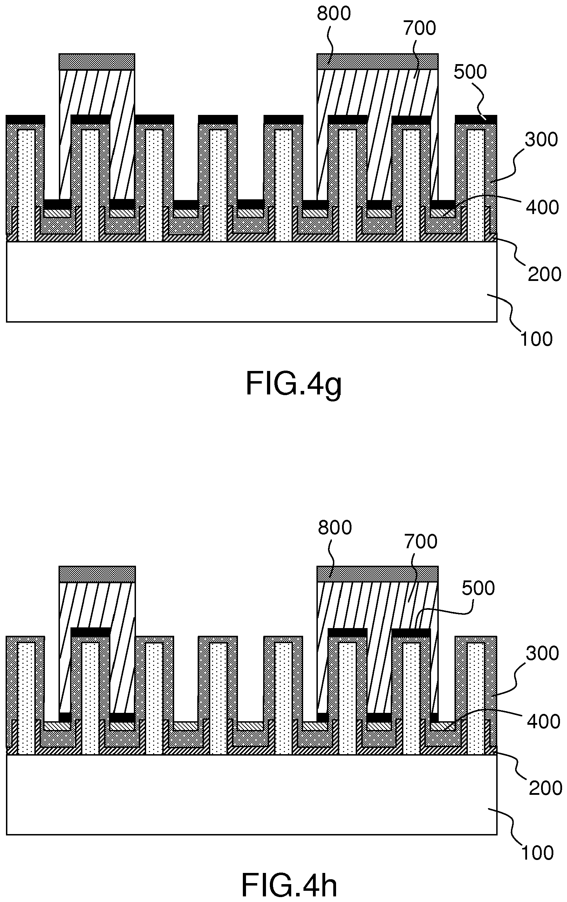

### Etape 7 illustrée en figure 4g :

On procède au retrait des motifs de résine de manière à laisser apparents les premiers nanofils destinés à être actifs.

### Etape 8 illustrée en figure 4h :

Puis, dans le cas de l'utilisation d'une structure d'accroche 500, sur la couche conductrice transparente 300 ou sur une structure miroir 400, on peut procéder à la gravure chimique sélective de cette structure.

Il est à noter que dans le cas d'une couche d'accroche en Ti/Al on peut conserver cette couche pour s'en servir comme couche miroir.

Typiquement on peut réaliser ce type de gravure sélective dans les couples : Ti/Cu par rapport à l'ITO ou par rapport à une structure miroir Ti/Al, en utilisant par exemple une solution de :
- H₂O₂ / H₂SO₄, dans le cas du cuivre ;
- HF 0,25 % dans le cas du titane.

L'élimination de la structure d'accroche peut également être effectuée par une opération de gravure sèche.

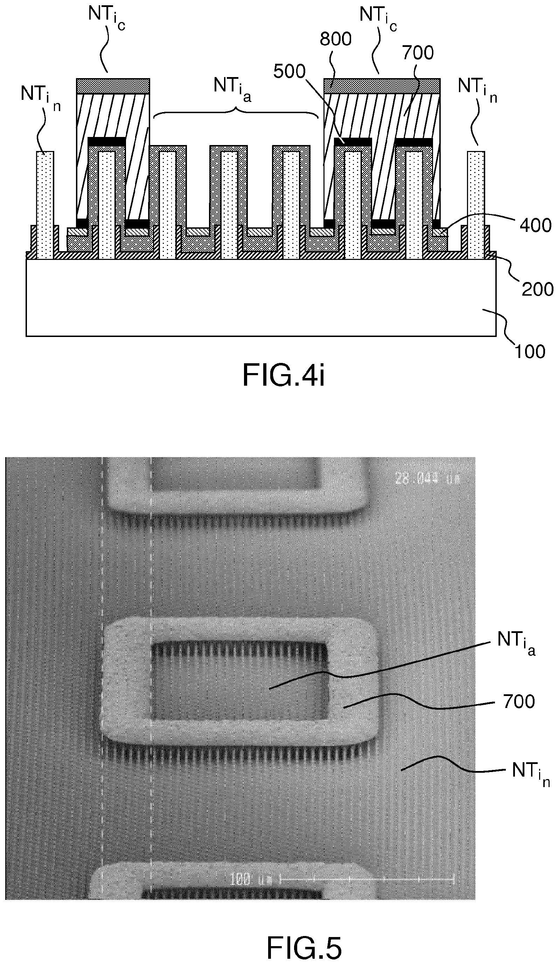

### Etape 8 illustrée en figure 4i :

On peut enfin avantageusement procéder au retrait de la couche transparente conductrice 300, en périphérie de l'ensemble des premiers nanofils et des seconds nanofils, de manière à circonscrire la partie active du dispositif, en neutralisant des nanofils, ainsi définis comme étant neutres , sans avoir recours à des opérations d'élimination de cesdits nanofils.

On obtient ainsi un exemple de dispositif selon la présente invention comprenant :
- la première série de premiers nanofils apparents et dits actifs NTiₐ;
- la seconde série de seconds nanofils sous les motifs de métal épais, dénommés nanofils de contact NTi_{c}.
- une troisième série de troisièmes nanofils neutres NTiₙ, dépourvus de la couche conductrice transparente et délimitant la partie dispositif électroluminescent sur le substrat ayant donné lieu à une opération globale de croissance de nanofils sur l'ensemble de la surface dudit substrat.

En variante du procédé précédemment décrit, il est tout aussi possible d'envisager de matérialiser les nanofils neutres NTiₙ en début de procédé avant les étapes de réalisation de motifs de résine, en procédant au retrait de la couche conductrice 300 au niveau des nanofils en périphérie.

Dans le cas de l'utilisation d'une couche d'accroche 400 au dessus de la couche conductrice 300, on procède alors au retrait des deux couches en périphérie pour définir les nanofils destinés à être des nanofils neutres.

Dans les deux cas que la couche 300 soit au dessus ou en dessous de la couche 400, il faut retirer ces deux couches dans la zone des nanofils neutres.

La figure 5 illustre une vue de dessus d'un exemple de configuration de couche épaisse de contact 700, à la surface d'un ensemble de nanofils NTi_{c}, situés entre des premiers nanofils NTiₐ et des troisièmes nanofils NTiₙ.

De manière générale, le second type de contact pour commander le dispositif électroluminescent est en face arrière, il peut typiquement s'agir d'une couche métallique déposée en face arrière du substrat pouvant être avantageusement en silicium.

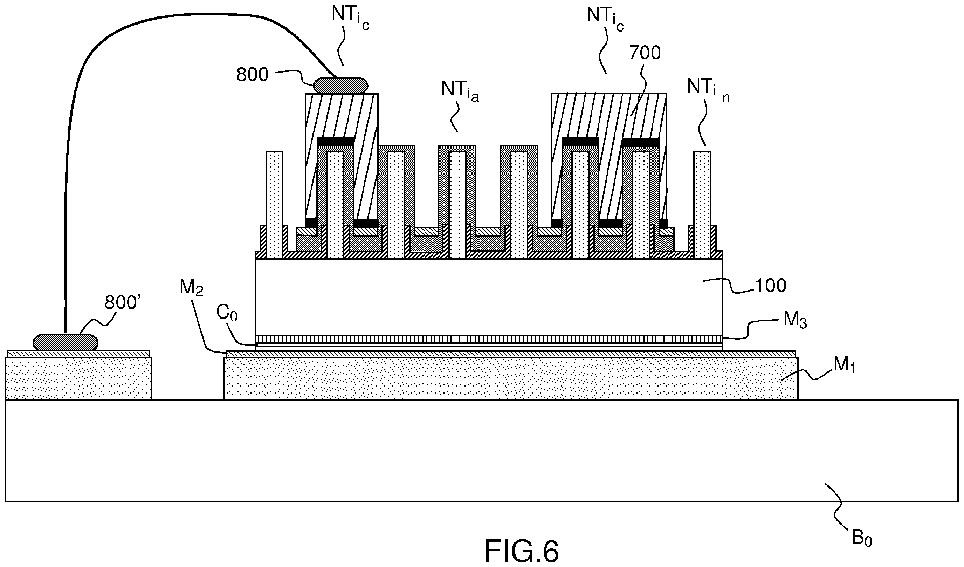

La figure 6 schématise le report d'un exemple de dispositif selon l'invention sur un boitier, et la connexion électrique depuis les deux types de contact : contact p et contact n. Le contact p est assuré depuis les NTi_{c} et les plots de contacts 800 et 800'. Le boîtier Bₒ est recouvert d'une couche de métal M₁ pouvant être en cuivre, d'une fine couche métallique M₂ pouvant être typiquement un flash d'or, ledit boîtier étant ainsi solidarisé audit dispositif électroluminescent en face arrière au niveau du substrat comportant une couche métallique M₃ pouvant typiquement être à base de Ti/Au et assurant le contact de type n, par une couche intermédiaire pouvant être une colle Co.

Il est à noter que les plots de bonding peuvent avoir des dimensions latérales plus faibles et ne pas occuper toute la surface supérieure des motifs de métal épais 700, tels que les plots de bonding 800 effectivement représentés en figure 6.

### Second exemple de procédé de fabrication d'un dispositif électroluminescent de l'invention

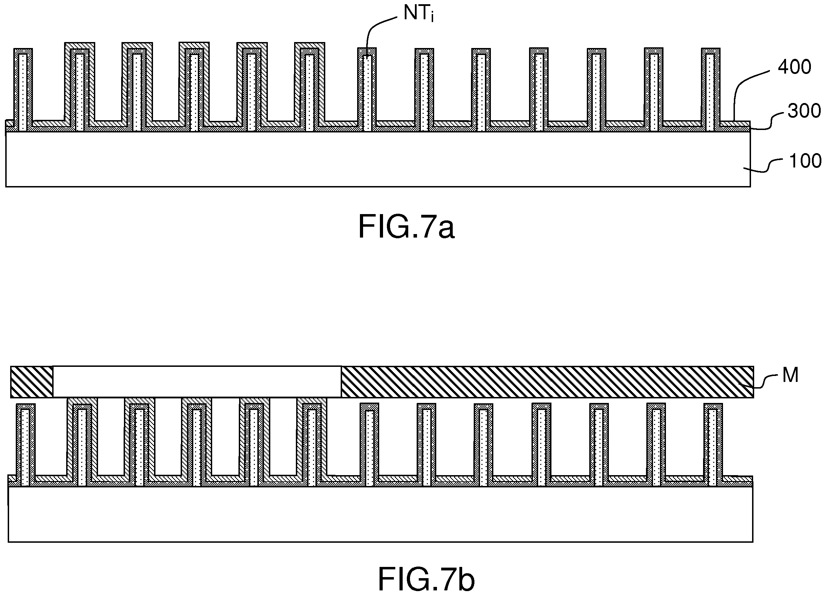

Il est également avantageusement possible de réaliser les contacts par dépôt de métal par un procédé de sérigraphie. Les figures 7a à 7d illustrent les principales étapes de ce type de procédé, qui ne représentent que la réalisation d'un seul sous-ensemble de nanofils de contact NTi_{c}, même si les nanofils NTiₐ peuvent avantageusement être compris entre deux sous-ensembles de nanofils NTi_{c}.

Les premières étapes peuvent être identiques à celles décrites en figure 4a et 4c.

A partir d'un substrat 100 comportant des nanofils NTi recouverts d'une couche conductrice transparente 300 et localement d'une couche miroir 400 comme illustré en figure 7a, on place un masque M comportant des ouvertures en regard des nanofils destinés à constituer les nanofils de contact, comme illustré en figure 7b.

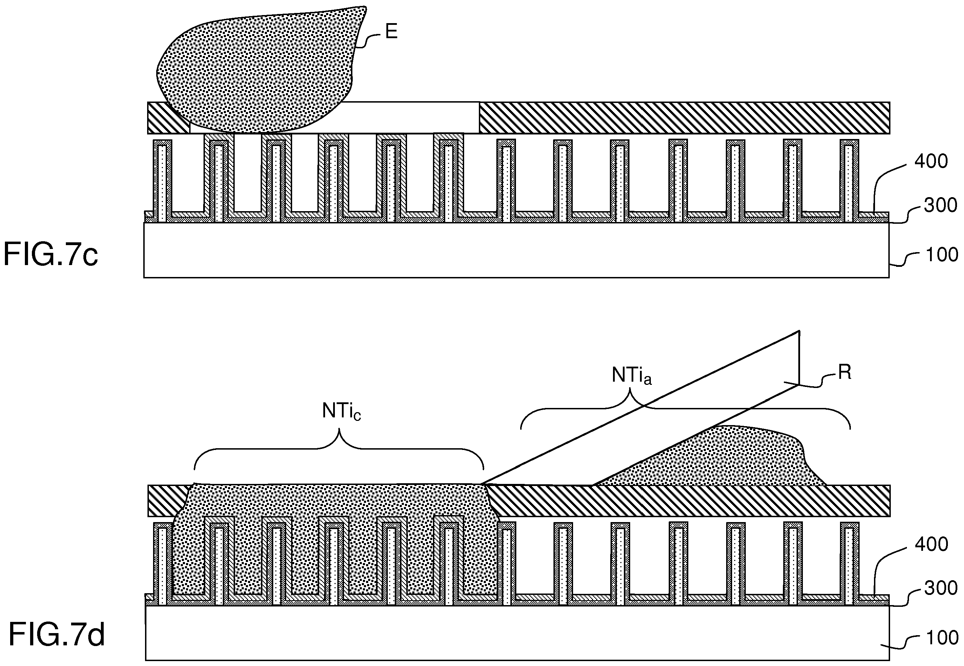

Au travers dudit masque M, on procède au dépôt d'une encre E métallique pouvant typiquement être en argent, comme illustré en figure 7c. On vient ensuite uniformiser l'épaisseur des contacts métalliques ainsi réalisés à l'aide d'une raclette R, comme illustré sur la figure 7d, et l'on définit ainsi les nanofils de contact NTi_{c}, recouverts d'une couche épaisse métallique, contigus aux nanofils actifs NTiₐ.

De manière analogue à ce qui est représenté en figure 4i, mais non représenté dans le présent exemple, il est possible avantageusement de procéder au retrait de la couche transparente conductrice 300 et de la couche miroir 400, en périphérie de l'ensemble des premiers nanofils et des seconds nanofils, de manière à circonscrire la partie active du dispositif, en neutralisant des nanofils, ainsi définis comme étant neutres, sans avoir recours à des opérations d'élimination de cesdits nanofils.

Selon ce procédé, la connexion électrique (bonding) avec un autre support métallisé, depuis la couche épaisse de premier contact, peut être réalisée directement.

### Troisième exemple de procédé de fabrication d'un dispositif électroluminescent de l'invention

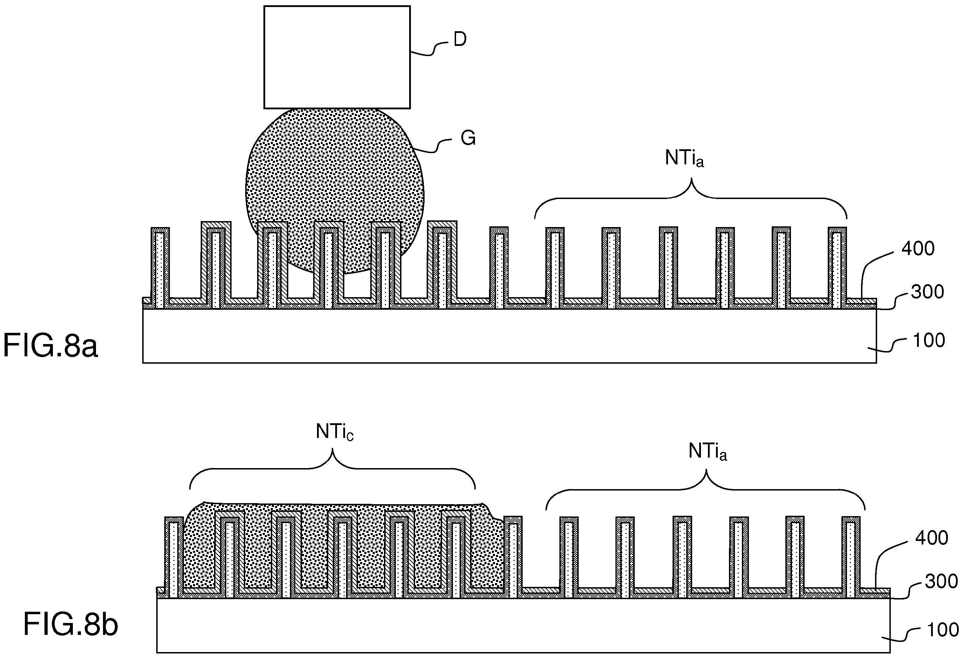

Il est encore avantageusement possible de réaliser les contacts par dépôt localisé de métal à l'aide d'un dispenseur. Les figures 8a et 8b illustrent ce troisième exemple de procédé de fabrication d'un dispositif électroluminescent de l'invention qui ne représentent que la réalisation d'un seul sous-ensemble de nanofils de contact NTi_{c}, même si les nanofils NTiₐ peuvent avantageusement être compris entre deux sous-ensembles de nanofils NTi_{c},

Les premières étapes peuvent être identiques à celles décrites en figure 4a et 4c.

A partir d'un substrat 100 comportant des nanofils NTi recouverts d'une couche conductrice transparente 300 et localement d'une couche miroir 400, on réalise le dépôt localisé d'une goutte de métal G, à l'aide d'un dispenseur D comme illustré en figure 8a. Le dispenseur D peut être typiquement une seringue. Ce dépôt métallique forme ainsi les contacts au niveau des nanofils de contact NTi_{c} contigus aux nanofils actifs NTiₐ , comme illustré en figure 8b. De manière analogue à ce qui est représenté en figure 4i, mais non représenté dans le présent exemple, il est possible avantageusement de procéder au retrait de la couche transparente conductrice 300 et de la couche miroir 400, en périphérie de l'ensemble des premiers nanofils et des seconds nanofils, de manière à circonscrire la partie active du dispositif, en neutralisant des nanofils, ainsi définis comme étant neutres, sans avoir recours à des opérations d'élimination de cesdits nanofils.

Selon ce procédé, la connexion électrique (bonding) avec un autre support métallisé, depuis la couche épaisse de premier contact, peut être réalisée directement.

### Quatrième exemple de procédé de fabrication d'un dispositif électroluminescent de l'invention

Il est encore avantageusement possible de réaliser les contacts par dépôt localisé de métal par une méthode de jet d'encre.

Ainsi, selon la présente invention, la taille des LEDs devient personnalisable, grâce au positionnement des zones de métal épais, et ce avantageusement assez tardivement dans les étapes de procédé.

Au-delà de la non-détérioration de certains nanofils, par des opérations de retrait, on peut gagner en nombre d'étapes de procédé (notamment toutes les étapes nécessaires en cas de suppression de nanofils).

Il est également avantageusement possible de positionner des contacts supérieurs intermédiaires au centre de matrices de grandes tailles, tout en bénéficiant de la possibilité d'électrodéposer des plots de bonding à la suite de la réalisation de la couche de métal épais de contact.

Enfin, il est à noter que le principe de la présente invention permet de fabriquer des dispositifs avec des coûts particulièrement intéressants.

## Revendications

1. Dispositif électroluminescent comprenant un ensemble de nanofils (NTi) sur l'ensemble de la surface d'un substrat (100), **caractérisé en ce que** :
- il comprend au moins une première série de premiers nanofils et une seconde série de seconds nanofils ;
- ladite première série comprenant des premiers nanofils dits actifs (NTiₐ) capables d'émettre de la lumière sous commande électrique, connectés entre un premier type de contact électrique et un second type de contact électrique pour permettre audit dispositif d'émettre de la lumière sous commande électrique, lesdits premiers nanofils étant recouverts d'au moins une couche (300) conductrice transparente à la longueur d'émission dudit dispositif électroluminescent, ladite couche étant en contact avec ledit premier type de contact électrique ;
- ladite seconde série comprenant des seconds nanofils dits de contact (NTi_{c}) encapsulés dans une couche de métal (700) permettant de constituer ledit premier type de contact électrique ;
- le second type de contact électrique étant situé en face arrière dudit substrat, opposée à la face comprenant lesdits nanofils et étant assuré par une couche conductrice en regard au moins de ladite première série de nanofils.

2. Dispositif électroluminescent selon la revendication 1, **caractérisé en ce que** lesdits seconds nanofils sont situés en périphérie desdits premiers nanofils.

3. Dispositif électroluminescent selon l'une des revendications 1 ou 2, **caractérisé en ce que** lesdits seconds nanofils sont recouverts par ladite couche (300) conductrice transparente à la longueur d'émission dudit dispositif électroluminescent.

4. Dispositif électroluminescent selon l'une des revendications 1 à 3, **caractérisé en ce qu'**il comprend une troisième série de troisièmes nanofils (NTiₙ) dits neutres électriquement sans couche conductrice transparente à la longueur d'émission dudit dispositif électroluminescent, lesdits troisièmes nanofils pouvant être situés en périphérie desdits premiers nanofils actifs et desdits seconds nanofils, définissant une zone dite active dudit dispositif.

5. Dispositif électroluminescent selon l'une des revendications 1 à 4, **caractérisé en ce que** l'épaisseur de la couche de métal définie au dessus desdits seconds nanofils est de l'ordre d'au moins quelques dizaines de nanomètres et **en ce que** la couche de métal encapsulant lesdits seconds nanofils est en cuivre ou en nickel ou en argent.

6. Dispositif électroluminescent selon l'une des revendications 1 à 5, **caractérisé en ce qu'**il comprend une couche miroir (400) située entre deux nanofils adjacents, pouvant être en Al ou en Ag ou en Ru.

7. Dispositif électroluminescent selon l'une des revendications 1 à 6, **caractérisé en ce qu'**il comporte des plots de contact métalliques (800) à la surface de ladite couche de métal (700), pouvant être en or ou en alliage d'argent et d'étain.

8. Dispositif électroluminescent selon l'une des revendications 1 à 7, **caractérisé en ce que** lesdits seconds nanofils sont recouverts par une couche (500) continue ou discontinue d'accroche pour le métal, pouvant être en cuivre ou en aluminium.

9. Procédé de fabrication de dispositif(s) électroluminescent(s) comprenant :
- un ensemble de nanofils (NTi) sur l'ensemble de la surface d'un substrat ;
- au moins une première série de premiers nanofils et une seconde série de seconds nanofils ;
- ladite première série comprenant des premiers nanofils dits actifs (NTiₐ) capables d'émettre de la lumière sous commande électrique, connectés entre un premier type de contact électrique et un second type de contact électrique pour permettre audit dispositif d'émettre de la lumière sous commande électrique, lesdits premiers nanofils étant recouverts d'au moins une couche (300) conductrice transparente à la longueur d'émission dudit dispositif électroluminescent, ladite couche étant en contact avec ledit premier type de contact électrique ;
- ladite seconde série comprenant des seconds nanofils dits de contact (NTi_{c}) encapsulés dans une couche de métal (700) permettant de constituer ledit premier type de contact électrique ;
- le second type de contact électrique étant situé en face arrière dudit substrat, opposée à la face comprenant lesdits nanofils et étant assuré par une couche conductrice au moins en regard de ladite première série de nanofils.
**caractérisé en ce qu'**il comporte les étapes suivantes :
- la croissance de nanofils (NTᵢ) sur l'ensemble de la surface d'un substrat (100) ;
- le dépôt d'une couche (300) conductrice transparente à la longueur d'onde de fonctionnement du dispositif électroluminescent, à la surface d'au moins une partie desdits nanofils ;
- l'encapsulation locale par une couche de métal (700) d'un sous-ensemble de nanofils constituant lesdits seconds nanofils dits de contact permettant de constituer ledit premier type de contact électrique ;
- la réalisation du second type de contact en face arrière du substrat, par une couche conductrice.

10. Procédé de fabrication de dispositif(s) électroluminescent(s) selon la revendication 9, **caractérisé en ce qu'**il comprend :
- la réalisation de motifs épais de résine (600) à la surface d'au moins deux premiers sous-ensembles de premiers nanofils (NTiₐ) laissant au moins un second sous-ensemble de seconds nanofils (NTi_{c}) non recouverts de ladite résine ;
- le dépôt d'une couche de métal, à la surface desdits seconds nanofils (NTi_{c}) pour assurer le premier type de contact électrique ;
- le retrait desdits motifs de résine au niveau desdits premiers nanofils (NTiₐ).

11. Procédé de fabrication de dispositif(s) électroluminescent(s) selon l'une des revendications 9 à 10, **caractérisé en ce qu'**il comporte une étape de retrait de la couche (300) conductrice et transparente à la longueur d'onde d'émission dudit dispositif électroluminescent au niveau de nanofils situés en périphérie desdits premiers et seconds nanofils, de manière à définir une troisième série de troisièmes nanofils (NTiₙ).

12. Procédé de fabrication de dispositif(s) électroluminescent(s) selon l'une des revendications 10 ou 11, **caractérisé en ce que** le dépôt de la couche de métal et/ou la réalisation de plots conducteurs sont effectués par une opération d'électrodéposition.

13. Procédé de fabrication de dispositif(s) électroluminescent(s) selon l'une des revendications 10 ou 11, **caractérisé en ce qu'**il comprend le dépôt d'au moins une couche d'accroche (500) destinée à l'accroche dudit métal, ledit dépôt pouvant être réalisé :
- de manière continue sur l'ensemble desdits nanofils et entre deux nanofils adjacents au niveau dudit substrat ou ;
- de manière discontinue aux extrémités desdits nanofils et entre deux nanofils adjacents au niveau dudit substrat ou ;
- entre deux nanofils adjacents au niveau dudit substrat.

14. Procédé de fabrication de dispositif(s) électroluminescent(s) selon la revendication 13, caractérisé en ce qu"il comprend une opération de retrait de ladite couche d'accroche au niveau desdits troisièmes nanofils ou desdits troisièmes nanofils et desdits premiers nanofils.

15. Procédé de fabrication de dispositif(s) électroluminescent(s) selon l'une des revendications 9 à 14, **caractérisé en ce qu'**il comprend le dépôt d'une couche miroir (400) entre deux nanofils adjacents, ledit dépôt étant préalable ou postérieur au dépôt de ladite couche conductrice transparente (300).

## Patentansprüche

1. Elektrolumineszierende Vorrichtung, die eine Anordnung von Nanodrähten (NTi) auf der gesamten Oberfläche eines Substrats (100) umfasst, **dadurch gekennzeichnet, dass**:
- sie wenigstens eine erste Serie von ersten Nanodrähten und eine zweite Serie von zweiten Nanodrähten umfasst;
- wobei die erste Serie erste, aktiv (NTiₐ) genannte Nanodrähte umfasst, die Licht elektrisch gesteuert emittieren können, verbunden zwischen einem ersten elektrischen Kontakttyp und einem zweiten elektrischen Kontakttyp, um es zuzulassen, dass die Vorrichtung Licht elektrisch gesteuert emittiert, wobei die ersten Nanodrähte mit wenigstens einer für die Emissionslänge der elektrolumineszierenden Vorrichtung transparenten leitfähigen Schicht (300) bedeckt sind, wobei die Schicht mit dem ersten elektrischen Kontakttyp in Kontakt ist;
- wobei die zweite Serie Kontaktnanodrähte (NTi_{c}) genannte zweite Nanodrähte umfasst, verkapselt in einer Metallschicht (700), die es zulässt, den ersten elektrischen Kontakttyp zu bilden;
- wobei sich der zweite elektrische Kontakttyp auf der Rückseite des Substrats gegenüber der Fläche befindet, die die Nanodrähte umfasst und durch eine leitfähige Schicht bereitgestellt wird, die wenigstens der ersten Serie von Nanodrähten gegenüberliegt.

2. Elektrolumineszierende Vorrichtung nach Anspruch 1, **dadurch gekennzeichnet, dass** sich die zweiten Nanodrähte an der Peripherie der ersten Nanodrähte befinden.

3. Elektrolumineszierende Vorrichtung nach Anspruch 1 oder 2, **dadurch gekennzeichnet, dass** die zweiten Nanodrähte mit der für die Emissionslänge der elektrolumineszierenden Vorrichtung transparenten leitfähigen Schicht (300) bedeckt sind.

4. Elektrolumineszierende Vorrichtung nach einem der Ansprüche 1 bis 3, **dadurch gekennzeichnet, dass** sie eine dritte Serie von elektrisch neutral genannten dritten Nanodrähten (NTiₐ) ohne eine für die Emissionslänge der elektrolumineszierenden Vorrichtung transparente leitfähige Schicht umfasst, wobei sich die dritten Nanodrähte an der Peripherie der ersten aktiven Nanodrähte und der zweiten Nanodrähte befinden können, die eine aktiv genannte Zone der Vorrichtung definieren.

5. Elektrolumineszierende Vorrichtung nach einem der Ansprüche 1 bis 4, **dadurch gekennzeichnet, dass** die Dicke der über den zweiten Nanodrähten definierten Metallschicht in der Größenordnung von wenigstens einigen Dutzend Nanometern liegt, und dadurch, dass die die zweiten Nanodrähte verkapselnde Metallschicht aus Kupfer oder Nickel oder Silber ist.

6. Elektrolumineszierende Vorrichtung nach einem der Ansprüche 1 bis 5, **dadurch gekennzeichnet, dass** sie eine Spiegelschicht (400) umfasst, die sich zwischen zwei benachbarten Nanodrähten befindet und aus Al oder aus Ag oder aus Ru sein kann.

7. Elektrolumineszierende Vorrichtung nach einem der Ansprüche 1 bis 6, **dadurch gekennzeichnet, dass** sie Metallkontaktstücke (800) auf der Oberfläche der Metallschicht (700) umfasst, die aus Gold oder aus einer Silber- und Zinnlegierung sein können.

8. Elektrolumineszierende Vorrichtung nach einem der Ansprüche 1 bis 7, **dadurch gekennzeichnet, dass** die zweiten Nanodrähte mit einer kontinuierlichen oder diskontinuierlichen Haftschicht (500) für das Metall bedeckt sind, die aus Kupfer oder Aluminium sein kann.

9. Verfahren zur Herstellung von einer oder mehreren elektrolumineszierenden Vorrichtungen, die Folgendes beinhaltet:
- eine Anordnung von Nanodrähten (NTi) auf der gesamten Oberfläche eines Substrats;
- wenigstens eine erste Serie von ersten Nanodrähten und eine zweite Serie von zweiten Nanodrähten;
- wobei die erste Serie erste, aktiv genannte Nanodrähte (NTiₐ) umfasst, die Licht elektrisch gesteuert emittieren können, verbunden zwischen einem ersten elektrischen Kontakttyp und einem zweiten elektrischen Kontakttyp, um es zuzulassen, dass die Vorrichtung Licht elektrisch gesteuert emittiert, wobei die ersten Nanodrähte mit wenigstens einer für die Emissionslänge der elektrolumineszierenden Vorrichtung transparenten leitfähigen Schicht (300) bedeckt sind, wobei die Schicht mit dem ersten elektrischen Kontakttyp in Kontakt ist;
- wobei die zweite Serie Kontaktnanodrähte (NTi_{c}) genannte zweite Nanodrähte umfasst, die in einer Metallschicht (700) verkapselt sind, die es zulässt, den ersten elektrischen Kontakttyp zu bilden;
- wobei sich der zweite elektrische Kontakttyp auf der Rückseite des Substrats gegenüber der Fläche befindet, die die Nanodrähte umfasst und durch eine leitfähige Schicht bereitgestellt wird, die wenigstens der ersten Serie von Nanodrähten gegenüberliegt;
**dadurch gekennzeichnet, dass** es die folgenden Schritte beinhaltet:
- Wachsenlassen von Nanodrähten (NT;) auf der gesamten Oberfläche eines Substrats (100);
- Absetzen einer für die Betriebswellenlänge der elektrolumineszierenden Vorrichtung transparenten leitfähigen Schicht (300) auf der Oberfläche wenigstens eines Teils der Nanodrähte;
- lokales Verkapseln, durch eine Metallschicht (700), einer Unteranordnung von Nanodrähten, die die Kontaktnanodrähte genannten zweiten Nanodrähte bilden, um es zuzulassen, den ersten elektrischen Kontakttyp zu bilden;
- Realisieren des zweiten Kontakttyps auf der Rückseite des Substrats durch eine leitfähige Schicht.

10. Verfahren zur Herstellung von einer oder mehreren elektrolumineszierenden Vorrichtungen nach Anspruch 9, **dadurch gekennzeichnet, dass** es Folgendes beinhaltet:
- Realisieren von dicken Harzmustern (600) auf der Oberfläche von wenigstens zwei ersten Unteranordnungen von ersten Nanodrähten (NTiₐ), die wenigstens eine zweite Unteranordnung von zweiten Nanodrähten (NTi_{c}) von dem Harz unbedeckt lassen;
- Absetzen einer Metallschicht auf der Oberfläche der zweiten Nanodrähte (NTi_{c}), um den ersten elektrischen Kontakttyp bereitzustellen;
- Entfernen der Harzmuster von den ersten Nanodrähten (NTiₐ).

11. Verfahren zur Herstellung von einer oder mehreren elektrolumineszierenden Vorrichtungen nach einem der Ansprüche 9 bis 10, **dadurch gekennzeichnet, dass** es einen Schritt des Entfernens der leitfähigen und für die Emissionswellenlänge der elektrolumineszierenden Vorrichtung transparenten Schicht (300) von den Nanodrähten beinhaltet, die sich an der Peripherie der ersten und der zweiten Nanodrähte befinden, um eine dritte Serie von dritten Nanodrähten (NTiₐ) zu definieren.

12. Verfahren zur Herstellung von einer oder mehreren elektrolumineszierenden Vorrichtungen nach Anspruch 10 oder 11, **dadurch gekennzeichnet, dass** das Absetzen der Metallschicht und/oder das Realisieren von leitfähigen Kontaktstücken durch einen Galvanisierungsvorgang erfolgen.

13. Verfahren zur Herstellung von einer oder mehreren elektrolumineszierenden Vorrichtungen nach Anspruch 10 oder 11, **dadurch gekennzeichnet, dass** es das Absetzen von wenigstens einer Haftschicht (500) zum Festhalten des Metalls beinhaltet, wobei das Absetzen realisiert werden kann:
- auf kontinuierliche Weise an der ganzen Anordnung der Nanodrähte und zwischen zwei benachbarten Nanodrähten an dem Substrat, oder
- auf diskontinuierliche Weise an den Enden der Nanodrähte und zwischen zwei benachbarten Nanodrähten an dem Substrat; oder
- zwischen zwei benachbarten Nanodrähten an dem Substrat.

14. Verfahren zur Herstellung von einer oder mehreren elektrolumineszierenden Vorrichtungen nach Anspruch 13, **dadurch gekennzeichnet, dass** es einen Vorgang des Entfernens der Haftschicht von den dritten Nanodrähten oder den dritten Nanodrähten und den ersten Nanodrähten beinhaltet.

15. Verfahren zur Herstellung von einer oder mehreren elektrolumineszierenden Vorrichtungen nach einem der Ansprüche 9 bis 14, **dadurch gekennzeichnet, dass** es das Absetzen einer Spiegelschicht (400) zwischen zwei benachbarten Nanodrähten beinhaltet, wobei das Absetzen vor oder nach dem Absetzen der transparenten leitfähigen Schicht (300) erfolgt.

## Claims

1. A light-emitting device comprising a set of nanowires (NTi) over the whole surface of a substrate (100), **characterized in that**:
- it comprises at least a first series of first nanowires and a second series of second nanowires;
- said first series comprising first nanowires referred to as active nanowires (NTiₐ) capable of emitting light under electrical control, connected between a first type of electrical contact and a second type of electrical contact in order to allow said device to emit light under electrical control, said first nanowires being covered by at least one conducting layer (300) being transparent at the emission wavelength of said light-emitting device, said layer being in contact with said first type of electrical contact;
- said second series comprising second nanowires referred to as contact nanowires (NTi_{c}) encapsulated within a metal layer (700) allowing said first type of electrical contact to be formed;
- the second type of electrical contact being situated on the back face of said substrate, opposite to the face comprising said nanowires and being provided by a conducting layer facing at least said first series of nanowires.

2. The light-emitting device as claimed in claim 1, **characterized in that** said second nanowires are situated around the periphery of said first nanowires.

3. The light-emitting device as claimed in claim 1 or 2, **characterized in that** said second nanowires are covered by said conducting layer (300) being transparent at the emission wavelength of said light-emitting device.

4. The light-emitting device as claimed in one of claims 1 to 3, **characterized in that** it comprises a third series of third nanowires (NTiₐ) referred to as electrically neutral nanowires without conducting layer being transparent at the emission wavelength of said light-emitting device, said third nanowires being able to be situated around the periphery of said first active nanowires and of said second nanowires, defining a region referred to as active region of said device.

5. The light-emitting device as claimed in one of claims 1 to 4, **characterized in that** the thickness of the metal layer defined on top of said second nanowires is of the order of at least a few tens of nanometres and **in that** the metal layer encapsulating said second nanowires is made of copper or of nickel or of silver.

6. The light-emitting device as claimed in one of claims 1 to 5, **characterized in that** it comprises a mirror layer (400) situated between two adjacent nanowires, which layer may be of Al or of Ag or of Ru.

7. The light-emitting device as claimed in one of claims 1 to 6, **characterized in that** it comprises metal contact lugs (800) on the surface of said metal layer (700), which lugs may be of gold or of an alloy of silver and tin.

8. The light-emitting device as claimed in one of claims 1 to 7, **characterized in that** said second nanowires are covered by a continuous or discontinuous adhesion layer (500) for the metal, which layer may be of copper or of aluminium.

9. A method for the fabrication of light-emitting device(s) comprising:
- a set of nanowires (NTi) over the entire surface of a substrate;
- at least a first series of first nanowires and a second series of second nanowires;
- said first series comprising first nanowires referred to as active nanowires (NTiₐ) capable of emitting light under electrical control, connected between a first type of electrical contact and a second type of electrical contact in order to allow said device to emit light under electrical control, said first nanowires being covered by at least one conducting layer (300) being transparent at the emission wavelength of said light-emitting device, said layer being in contact with said first type of electrical contact;
- said second series comprising second nanowires referred to as contact nanowires (NTi_{c}) encapsulated in a metal layer (700) allowing said first type of electrical contact to be formed;
- the second type of electrical contact being situated on the back face of said substrate, opposite to the face comprising said nanowires, and being provided by a conducting layer at least facing said first series of nanowires.
**characterized in that** it comprises the following steps:
- the growth of nanowires (NTi) over the whole surface of a substrate (100);
- the deposition of a conducting layer (300) being transparent at the wavelength of operation of the light-emitting device, on the surface of at least a part of said nanowires;
- the local encapsulation by a metal layer (700) of a sub-set of nanowires constituting said second nanowires, referred to as contact nanowires, allowing said first type of electrical contact to be formed;
- the formation of the second type of contact on the back face of the substrate, by a conducting layer.

10. The method of fabrication of light-emitting device(s) as claimed in claim 9, **characterized in that** it comprises:
- the formation of thick resin patterns (600) on the surface of at least two first subassemblies of first nanowires (NTiₐ) leaving at least a second sub-assembly of second nanowires (NTi_{c}) not covered by said resin;
- the deposition of a metal layer on the surface of said second nanowires (NTi_{c}) in order to provide the first type of electrical contact;
- the removal of said resin patterns from said first nanowires (NTiₐ).

11. The method of fabrication of light-emitting device(s) as claimed in one of claims 9 to 10, **characterized in that** it comprises a step for removal of the conducting layer (300) being transparent at the emission wavelength of said light-emitting device from nanowires situated around the periphery of said first and second nanowires, in such a manner as to define a third series of third nanowires (NTiₐ).

12. The method of fabrication of light-emitting device(s) as claimed in claim 10 or 11, **characterized in that** the deposition of the metal layer and/or the formation of the conducting lugs are carried out by an electrodeposition operation.

13. The method of fabrication of light-emitting device(s) as claimed in claim 10 or 11, **characterized in that** it comprises the deposition of at least one adhesion layer (500) designed for the adhesion of said metal, said deposition being able to be implemented:
- in a continuous manner on the whole set of said nanowires and between two adjacent nanowires at said substrate or;
- in a discontinuous manner at the ends of said nanowires and between two adjacent nanowires at said substrate or;
- between two adjacent nanowires at said substrate.

14. The method of fabrication of light-emitting device(s) as claimed in claim 13, **characterized in that** it comprises an operation for removal of said adhesion layer from said third nanowires or from said third nanowires and said first nanowires.

15. The method of fabrication of light-emitting device(s) as claimed in one of claims 9 to 14, **characterized in that** it comprises the deposition of a mirror layer (400) between two adjacent nanowires, said deposition being prior to or after the deposition of said transparent conducting layer (300).
